# EUROPÄISCHE PATENTSCHRIFT

(11) **EP 1 188 234 B1**
(45) Veröffentlichungstag und Bekanntmachung des Hinweises auf die Patenterteilung: **30.07.2003**
(21) Anmeldenummer: 00943655.1
(22) Anmeldetag: 30.05.2000
(51) Int. Cl.: H03H 7/38

(54) **SCHALTUNGSANORDNUNG ZUR ANPASSUNG EINES VERSTÄRKERS AN EINE HOCHFREQUENZLEITUNG UND VERWENDUNG DIESER SCHALTUNGSANORDNUNG**
CIRCUIT ARRAY FOR ADAPTING AN AMPLIFIER TO A HIGH FREQUENCY LINE AND UTILIZATION OF SAID CIRCUIT ARRAY
CIRCUIT POUR ADAPTER UN AMPLIFICATEUR A UNE LIGNE HAUTE FREQUENCE, ET UTILISATION DUDIT CIRCUIT

(30) Priorität: 24.06.1999 DE 19928942
(43) Veröffentlichungstag der Anmeldung: 20.03.2002
(73) Patentinhaber: Infineon Technologies AG, 81669 München (DE)
(72) Erfinder: BARTL, Thomas, D-83026 Rosenheim (DE)
(74) Vertreter: Epping Hermann & Fischer
(86) Internationale Anmeldenummer: DE0001758
(87) Internationale Veröffentlichungsnummer: WO01001568

(56) Entgegenhaltungen:
- EP-A- 0 920 128
- WO-A-98/37626
- US-A- 5 361 403

## Beschreibung

Die Erfindung betrifft eine Schaltungsanordnung zur Anpassung der Ausgangsimpedanz eines Verstärkers an eine Hochfrequenzleitung sowie eine Verwendung dieser Schaltungsanordnung. Die Schaltungsanordnung findet Verwendung bei der Anpassung von einzügigen Leistungsverstärkern für Dualband-Mobiltelefone. Bei einzügigen Leistungsverstärkern erfolgt die Anpassung an das 900 MHz (GSM, D1, D2-Netz) oder 1800 MHz Band durch die Umschaltung der Anpaßschaltung.

Bisher war bei einzügigen Leistungsverstärkern zur Umschaltung der Anpaßschaltung nachteilhafterweise neben einer positiven Spannungsquelle auch eine externe negative Spannungsquelle notwendig.

Dualband-Funktelefone mit zweizügigen Verstärkern sind durch die notwendigerweise doppelte Ausführung der Sendezweige bis zur Antenne kostenintensiv.

In der DE 32 10 453 C2 sind verschiedene Schaltungsvarianten für eine Signal-Eingangsschaltung unter Verwendung einer PIN-Diode gezeigt. Die PIN-Diode ist jeweils über Reaktanzelemente an den Signaleingang angeschlossen. Der andere Anschluß der Diode ist gegebenenfalls über einen Kondensator mit Masse verbunden. Das Signal wird über eine Induktivität an ein als Transistor ausgeführtes Verstärkerelement weitergeleitet.

In der EP-A-0 920 128 ist eine Schaltung zur Impedanzanpassung einer Hochfrequenzleitung gezeigt. Sie weist eine erste Kapazität auf, die einerseits an die Hochfrequenzleitung angeschlossen ist und andererseits mit einem ersten als Anode dienenden Anschluß einer ersten Diode sowie mit einem ersten Anschluß einer ersten Induktivität. Der zweite als Kathode dienende Anschluß der ersten Diode ist über eine weitere Induktivität mit Bezugspotential verbunden. Der zweite Anschluß der ersten Induktivität ist über einen Widerstand mit einem zweiten Versorgungspotential verbunden.

Die US-A-5 361 403 zeigt verschiedene Anpassungsfilternetzwerke zur Impedanzanpassung eines Hochfrequenzverstärkers. Über mit Bezugspotential verbundene Schalter kann eine Reaktanz bzw. ein Kondensator an die Hochfrequenzleitung zugeschaltet werden.

Eine Aufgabe der Erfindung ist es, eine Schaltungsanordnung zur Anpassung eines Verstärkers an eine Hochfrequenzleitung anzugeben, die sowohl mit einem Sendezweig für zwei verschiedene Frequenzbänder als auch ohne eine externe negative Spannungsquelle auskommt. Eine weitere Aufgabe der Erfindung besteht in der Angabe einer Verwendung für die Schaltungsanordnung.

Die Aufgabe betreffend die Schaltungsanordnung wird erfindungsgemäß durch eine Schaltungsanordnung gemäß den in Patentanspruch 1 angegebenen Merkmalen gelöst.

Eine Verwendung dieser Schaltungsanordnung ist in Patentanspruch 6 angegeben.

Die erfindungsgemäße Schaltungsanordnung zur Anpassung eines Verstärkers an eine Hochfrequenzleitung weist eine erste Kapazität auf, die einerseits mit der Hochfrequenzleitung und andererseits mit einem Anschluß einer ersten Diode, einer Induktivität und einer zweiten Diode verbunden ist. Der zweite Anschluß der ersten Diode ist mit einem ersten Potential verbunden. Der zweite Anschluß der Induktivität ist über einen ersten Widerstand sowohl mit einem zweiten Widerstand als auch über ein Mittel zum Schalten mit einem zweiten Potential verbunden. Der zweite Anschluß der zweiten Diode ist mit dem zweiten Widerstand und über eine zweite Kapazität mit dem ersten Potential verbunden.

Vorteilhafte Weiterbildungen der Erfindung sind in den abhängigen Patentansprüchen angegeben.

So ist es beispielsweise von Vorteil, einen dritten Widerstand zwischen die zweite Diode und die Induktivität zu schalten. Dadurch kann der Strom, der durch die zweite Diode fließt begrenzt werden.

Die Erfindung wird im folgenden anhand zweier Figuren näher erläutert.

Figur 1 zeigt die erfindungsgemäße Schaltung zur Anpassung eines Verstärkers an eine Hochfrequenzleitung.

Figur 2 zeigt das Übertragungsverhalten der Schaltung für das 900 MHz und das 1800 MHz Band.

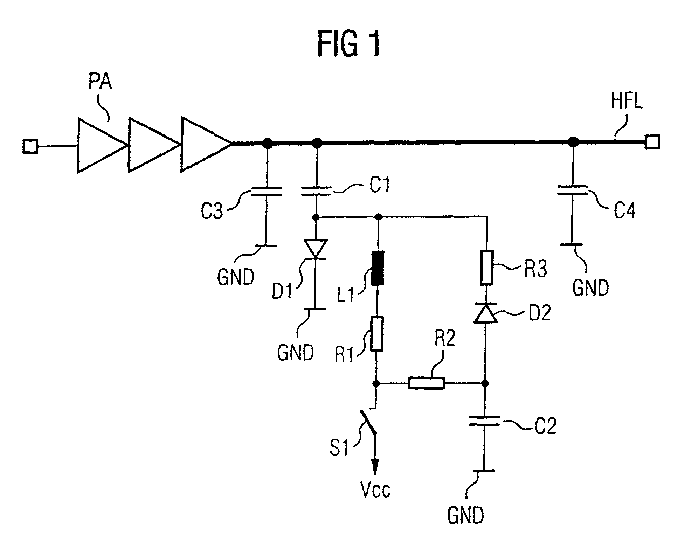

Bei der in Figur 1 gezeigten Schaltung zur Anpassung eines Verstärkers PA an eine Hochfrequenzleitung HFL ist eine erste Kapazität C1 vorgesehen, die einerseits mit der Hochfrequenzleitung HFL und andererseits mit der Anode einer ersten Diode D1, einem Anschluß einer Induktivität L1, und über einen Widerstand R3 mit der Kathode einer zweiten Diode D2 verbunden ist. Die Kathode der ersten Diode D1 ist mit einem ersten Potential GND verbunden. Der zweite Anschluß der Induktivität L1 ist über einen ersten Widerstand R1 sowohl mit einem zweiten Widerstand R2 als auch über ein Mittel zum Schalten S1 mit einem zweiten Potential Vcc verbunden. Die Anode der zweiten Diode D2 ist mit dem zweiten Widerstand R2 und über eine zweite Kapazität C2 mit dem ersten Potential GND verbunden. Eine dritte Kapazität C3 ist in der Nähe des Verstärkers PA einerseits mit der Hochfrequenzleitung HFL und andererseits mit dem ersten Potential GND verbunden. Eine vierte Kapazität C4 ist vom Verstärker PA aus betrachtet hinter der ersten Kapazität C1 mit der Hochfrequenzleitung HFL einerseits und andererseits mit dem ersten Potential GND verbunden.

Die erste Diode D1 ist vorteilhafterweise eine PIN-Diode, die zweite Diode D2 eine Schottky-Diode. Als Mittel zum Schalten S1 dient ein NF-Transistor. Die Hochfrequenzleitung HFL ist eine 50 Ohm Leitung, welche vorzugsweise als Mikrostreifenleitung ausgebildet ist.

Für den Fall, daß die Anpassung an das 900 MHz Band (GSM, D1, D2-Netz) erfolgen soll, wird der PIN-Diode D1 ein Strom eingeprägt, was durch Schließen des Schalters S1 geschieht, das heißt der Knotenpunkt der Widerstände R1 und R2 liegt auf dem zweiten Potential Vcc. Dadurch wird die PIN-Diode D1 sehr niederohmig. Die Höhe des Stroms, der durch die Induktivität L1 und die Diode D1 fließt, wird durch den Widerstand R1 festgelegt. Die Induktivität L1 dient als Tiefpaßfilter zur Abschirmung hochfrequenter Signale. Dadurch, daß die Diode D1 leitend geschaltet ist, liegt der Kondensator C1 annähernd auf dem ersten Potential GND.

Falls der Verstärker PA im 1800 MHz Band arbeiten soll, wird zur Leistungsanpassung die PIN-Diode D1 hochohmig gemacht, indem eine ausreichend hohe gegenüber dem ersten Potential GND negative Spannung an die Anode der Diode D1 angelegt wird. Dies wird dadurch erreicht, daß der Schalter S1 geöffnet wird, so daß das zweite Bezugspotential Vcc nicht mehr am Knotenpunkt der Widerstände R1 und R2 anliegt, so daß die im Kondensator C2 gespeicherte negative Halbwelle des Sendesignals über den Widerstand R2, den Widerstand R1 und die Induktivität L1 am Knotenpunkt zwischen dem Kondensator C1 und der Diode D1 anliegt. Der Kondensator C2 wurde zuvor über den Kondensator C1, den Widerstand R3 und die Diode D2 während der negativen Halbwelle des Sendesignals aufgeladen. Der Widerstand R3 muß dabei so groß gewählt werden, daß die Hochfrequenzverluste klein gehalten werden können. Der Widerstand R2 ist hochohmig zu dimensionieren. Während der positiven Halbwelle des Sendesignals kann ein begrenzter Entladevorgang über die Widerstände R2 und R1, die Induktivität L1 und die Diode D1 erfolgen.

Der Widerstand R3 dient der Strombegrenzung.

Über den Kondensator C1, auch als Anpaßkondensator bezeichnet, erfolgt die Auskopplung der HF-Spannung, die mit Hilfe der Schottky-Diode D2 und des Kondensators C2 gleichgerichtet wird. Diese negative gespeicherte Spannung wird zur Diode D1 rückgeführt.

Wird die Schaltung bei 900 MHz betrieben, so bestimmt der Widerstand R1 den Stromfluß durch die Diode D1.

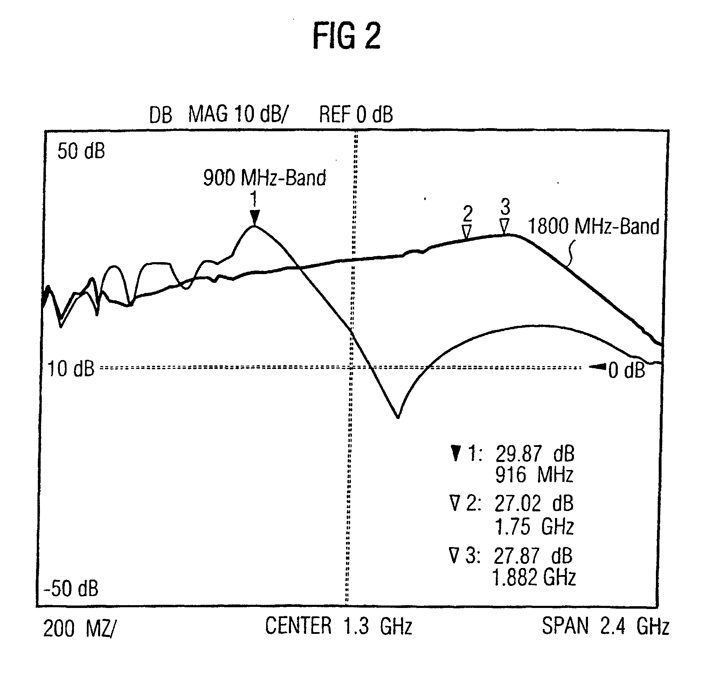

Bei dem in Figur 2 gezeigten Diagramm ist das Übertragungsverhalten der Schaltung gemäß Figur 1 beim 900 MHz Band und beim 1,8 MHz Band gezeigt. Auf der Abzisse des Diagramms ist die Frequenz in 200 MHz Schritten und auf der Ordinate die Dämpfung in 10 dB Schritten aufgetragen. Aus dem Diagramm ist erkennbar, daß das Sendesignal beim Betrieb im 900 MHz Band die optimale Anpassung aufweist. Aus dem Diagramm ist auch ersichtlich, daß das Sendesignal beim Betrieb im 1,8 GHz Band optimal angepaßt ist.

Das 1800 MHz Band wird oftmals auch als PCN oder GSM 1800 Band bezeichnet.

Vorteilhafterweise benötigt die erfindungsgemäße Schaltung keinen zusätzlichen negativen Spannungsgenerator, was sich insbesondere bei Schaltungen mit Hetero-Bipolar-Transistoren (HBTs) positiv auswirkt.

## Patentansprüche

1. Schaltungsanordnung zur Anpassung eines Verstärkers an eine Hochfrequenzleitung,
- bei der eine erste Kapazität (C1) vorgesehen ist, die einerseits mit der Hochfrequenzleitung (HFL) und andererseits mit einem ersten Anschluß einer ersten Diode (D1), einem ersten Anschluß einer Induktivität (L1) und einem ersten Anschluß einer zweiten Diode (D2) verbunden ist,
- bei der der zweite Anschluß der ersten Diode (D1) mit einem ersten Potential (GND) verbunden ist,
- bei der der zweite Anschluß der Induktivität (L1) über einen ersten Widerstand (R1) sowohl mit einem ersten Anschluß eines zweiten Widerstandes (R2) als auch über ein Mittel zum Schalten (S1) mit einem zweiten Potential (Vcc) verbunden ist,
- bei der der zweite Anschluß der zweiten Diode (D2) mit einem zweiten Anschluß des zweiten Widerstandes (R2) und über eine zweite Kapazität (C2) mit dem ersten Potential (GND) verbunden ist.

2. Schaltungsanordnung nach Patentanspruch 1,
bei der die erste Diode (D1) eine PIN-Diode ist.

3. Schaltungsanordnung nach Patentanspruch 1 oder 2,
bei der die zweite Diode (D2) eine Schottky-Diode ist.

4. Schaltungsanordnung nach einem der Patentansprüche 1 bis 3,
bei der das Mittel zum Schalten (S1) ein NF-Transistor ist.

5. Schaltungsanordnung nach einem der Patentansprüche 1 bis 4,
bei der ein dritter Widerstand (R3) zwischen die zweite Diode (D2) und die Induktivität (L1) geschaltet ist.

6. Verwendung der Schaltungsanordnung nach einem der Patentansprüche 1 bis 5
in einem Dualband-Funktelefon mit einem für verschiedene Frequenzbänder nutzbaren Sendepfad.

## Claims

1. Circuit arrangement for matching an amplifier to a radio-frequency line,
- in which a first capacitance (C1) is provided, which is connected firstly to the radio-frequency line (HFL) and secondly to a first connection of a first diode (D1), a first connection of an inductance (L1) and a first connection of a second diode (D2),
- in which the second connection of the first diode (D1) is connected to a first potential (GND),
- in which the second connection of the inductance (L1) is connected via a first resistor (R1) both to a first connection of a second resistor (R2) and, via a means for switching (S1), to a second potential (Vcc), and
- in which the second connection of the second diode (D1) is connected to a second connection of the second resistor (R2) and, via a second capacitance (C2), to the first potential (GND).

2. Circuit arrangement according to Patent Claim 1,
in which the first diode (D1) is a PIN diode.

3. Circuit arrangement according to Patent Claim 1 or 2,
in which the second diode (D2) is a Schottky diode.

4. Circuit arrangement according to one of Patent Claims 1 to 3,
in which the means for switching (S1) is an AF transistor.

5. Circuit arrangement according to one of Patent Claims 1 to 4,
in which a third resistor (R3) is connected between the second diode (D2) and the inductance (L1).

6. Use of the circuit arrangement according to one of Patent Claims 1 to 5,
in a dual-band radio telephone having a transmission path which can be used for different frequency bands.

## Revendications

1. Circuit d'adaptation d'un amplificateur à une ligne haute fréquence,
- dans lequel il est prévu une première capacité (C1) qui est reliée d'une part à la ligne (HFL) haute fréquence, et d'autre part à une première borne d'une première diode (D1), à une première borne d'une inductance (L1) et à une première borne d'une deuxième diode (D2),
- dans lequel la deuxième borne de la première diode (D1) est reliée à un premier potentiel (GND),
- dans lequel la deuxième borne de l'inductance (L1) est reliée par l'intermédiaire d'une première résistance (R1), tant à une première borne d'une deuxième résistance (R2) que par un moyen de commutation (S1) à un deuxième potentiel (Vcc),
- dans lequel la deuxième borne de la deuxième diode (D2) est reliée à une deuxième borne de la deuxième résistance (R2) et par une deuxième capacité (C2) au premier potentiel (GND).

2. Circuit suivant la revendication 1,
dans lequel la première diode (D1) est une diode PIN.

3. Circuit suivant la revendication 1 ou 2,
dans lequel la deuxième diode (D2) est une diode Schottky.

4. Circuit suivant l'une des revendications 1 à 3,
dans lequel le moyen de commutation (S1) est un transistor NF.

5. Circuit suivant l'une des revendications 1 à 4,
dans lequel une troisième résistance (R3) est montée entre la deuxième diode (D2) et l'inductance (L1).

6. Utilisation du circuit suivant l'une des revendications 1 à 5, dans un radiotéléphone à bande duale ayant un trajet d'émission utilisable pour diverses bandes de fréquence.
